**Europäisches Patentamt**

**European Patent Office**

**Office européen des brevets**

(11) Publication number : **0 412 007 B1**

# EUROPEAN PATENT SPECIFICATION

(45) Date of publication of patent specification :
07.12.94 Bulletin 94/49

(51) Int. Cl.⁵ : **H01L 39/24**

(21) Application number : **90402197.9**

(22) Date of filing : **31.07.90**

(54) Process for preparing superconducting thin films.

(30) Priority : **31.07.89 JP 198647/89**

(43) Date of publication of application :
06.02.91 Bulletin 91/06

(45) Publication of the grant of the patent :
07.12.94 Bulletin 94/49

(84) Designated Contracting States :
DE FR GB

(56) References cited :
EP-A- 0 342 009
PATENT ABSTRACTS OF JAPAN vol. 13, no. 328 (C-621)(3676), 24 July 1989; & JP - A - 1-104763
APPLIED PHYSICS LETTERS vol. 53, no. 17, 24 October 1988, pages 1660-1662, New York, US; D.G. SCHLOM et al.: "Molecular beam epitaxy of layered Dy-Ba-Cu-O compounds"
PATENT ABSTRACTS OF JAPAN vol. 13, no. 292 (E-782)(3640), 6 July 1989; & JP - A - 173776

(56) References cited :
APPLIED PHYSICS LETTERS vol. 54, no. 8, 20 February 1989, pages 754-756, New York, US; X.D. WU et al.: "High critical currents inepitaxial YBa2Cu307-x thin films on silicon with buffer layers"

(73) Proprietor : **SUMITOMO ELECTRIC INDUSTRIES, LTD.**
5-33, Kitahama 4-chome,
Chuo-ku
Osaka-shi, Osaka 541 (JP)

(72) Inventor : **Harada, Keizo, C/o Itami Sumitomo Elc. Ind. Ltd.**
1-1 Koyakita 1-chome
Itami-shi, Hyogo (JP)
Inventor : **Itozaki, Hideo, C/o Itami Sumitomo Elc. Ind. Ltd.**
1-1 Koyakita 1-chome
Itami-shi, Hyogo (JP)

(74) Representative : **Phélip, Bruno et al**
c/o Cabinet Harlé & Phélip
21, rue de La Rochefoucauld
F-75009 Paris (FR)

EP 0 412 007 B1

## Description

### Background of the Invention

#### Field of the invention

The present invention relates to a process for preparing superconducting thin films. More particularly, it relates to a process for depositing a superconducting thin films of compound oxides on substrates by vacuum evaporation techniques such as molecular beam epitaxy (hereinafter MBE) method.

#### Description of the related art

Among a variety of thin film formation techniques on substrates, vacuum evaporation methods are widely used because film formation is realized under very low pressures so that a variety of properties of a thin film can be analyzed advantageously during their growing stage.

An activated reactive evaporation method is one of techniques to prepare thin films of compounds. In this method, material vapors which are evaporated in an active gas atmosphere are reacted on a substrate. The MBE method is advantageous for preparing thin films of multi-component compounds because of the easiness of control of compositions. In some compounds, these two methods are combined together to prepare their thin films.

When thin films of oxides are prepared by the vacuum evaporation methods oxygen gas, as the active gas, is introduced into a chamber. It is known to activate or excite the oxygen gas by microwave or other radiations in order to increase its activity before an oxide thin film is deposited on a substrate.

D. G. Schlom et al. "Applied Physics Letters, 53 (17) p 1660 to 1662 discloses a process for preparing an oxide thin film on a substrate by a vacuum evaporation method (MBE) comprising the introduction of an excited oxygen gas (oxygen plasma) in the neighbourhood of the substrate. In this process, a vacuum chamber of a MBE unit must be evacuated to a pressure below $1,33 \ 10^{-2}Pa \ (10^{-4}Torr)$ and hence a plasma generating zone becomes such a low pressure value as several tens Pa (hunderds milli-Torr) to several hunhundreds Pa (Torr).However, it is difficult to produce a stable plasma under such low pressures. Still more, majority of active oxygen exited by the plasma drop to their ground states before they arrive at a substrate, so that the activity of oxygen is low. In the case of superconducting thin films of compound oxide, the content of oxygen in the thin film is one of critical factors and must be controlled precisely. From this point, this process is not effective to prepare oxide superconducting thin films of high quality.

An object of the present invention is to solve the problems raised by prior art and to provide a process which permits to prepare oxide thin films having predetermined oxygen content and of high quality.

### Summary of the Invention

The present invention provides a process for preparing an oxide thin film on a substrate by a vacuum evaporation method with an oxygen-containing gas excited by microwave discharge being introduced in the neighbourhood of the substrate, characterized in that the oxygen-containing gas is a mixed gas of $O_2$ and $N_2$.

Although the process according to the present invention is applicable to formation of any oxide thin films on substrates, it is particularly and advantageously applicable for depositing superconducting thin films of compound oxides whose oxygen content is a critical factor in order to realize superconducting properties.

A variety of superconducting compound oxides are knpwn. Followings are examples to which the process according to the present invention is advantageously applicable:

(1) YBCO type superconductors:

$$Ln_1 Ba_2 Cu_3 O_{7-z}$$

in which "Ln" stands for at least one element selected from a group comprising La, Ce, Pr, Nd, Sm, Eu, Gd, Tb, Dy, Ho, Y, Er, Tm, Yb, and Lu, and "z" is a number satisfying a range of $0 \leqq z < 1$.

(2) Bismuth type superconductors:

$$Bi_4 (Sr_{1-x}, Ca_x)_m Cu_n O_{p+y}$$

in which "x", "m", "n", "p" and "y" are numbers each satisfying ranges of $6 \leqq m \leqq 10$, $4 \leqq n \leqq 8$ $0 < x < 1$ and $-2 \leqq y \leqq +2$, respectively and p = (6+m+n). Particularly, following compositions are preferable:

(i) $7 \leqq m \leqq 9$,     $5 \leqq n \leqq 7$     $0.4 < x < 0.6$

(ii) $6 \leqq m \leqq 7$,     $4 \leqq n \leqq 5$     $0.2 < x < 0.4$

(iii) $9 \leqq m \leqq 10$,     $7 \leqq n \leqq 8$     $0.5 < x < 0.7$

(3) "La" type superconductors:

$$(La_{1-x}, \alpha)_2 Cu O_{4-y}$$

in which "$\alpha$" stands for Sr or Ba, and "x" and "y" are numbers each satisfying respective range of $0 \leq x < 1$ and $0 \leq y < 1$.

Of course, the process according to the present invention is not limited to these special compound oxides.

Selection of the substrate on which the oxide thin film is formed depends on kinds and applications of the oxide to be deposited. The substrate and the oxide thin films can be combined from a wide variety.

In the case of superconducting tin films of compound oxides, the substrate is preferably made of oxides, more preferably single crystal oxides. The preferable single crystal oxides are $MgO$, $SrTiO_3$, $LaGaO_3$, $NdGaO_3$, $LaAlO_3$ or YSZ. In a special case, a single crystal of semiconductors such as silicon may be used.

Although the process according to the present invention can be carried out by any vacuum evaporation technique including vacuum deposition method, sputtering method, ion-plating method or the like, the process according to the present invention is advantageous when superconducting thin films of compound oxide whose oxygen content is critical is prepared by the MBE method in which the control of oxygen supply is difficult.

In the MBE method, constituent elements of an oxide to be deposited are evaporated by means of Kunudsen Cells (K-cells) while activated oxygen gas, as a reaction gas, is supplied in the neighbourhood of a surface of the substrate. As stated above, in prior art, it was difficult to handle or control the activated oxygen excited by microwave.

The present invention resides in that a mixed gas of $O_2$ and $N_2$ which is excited by microwave is supplied in the neighbourhood of a substrate at the same time as a thin film of oxide is deposited by a vacuum evaporation method, particularly by the MBE method.

Following advantages are expected by using the mixed gas of $O_2$ and $N_2$ :

(1) A stable plasma can be created by microwave discharge even in such a very low pressure as several tens Pa (hundreds milli-Torr) to several hundreds Pa (Torr) which is indispensable to maintain necessary vacuum in a chamber, and

(2) The amount of activated oxygen which will arrive at the substrate increase because a zone in which the plasma is generated becomes wider in comparison with a case when oxygen gas is used (namely, the plasma zone becomes longer in a pipe in which the plasma is created).

From these advantages, the process according to the present invention is particularly effective for preparation of thin films of oxide superconductors which are very sensitive to the oxygen contents.

A proportion of $N_2$ is preferably in a range of 5 to 80 % by volume. If the proportion of $N_2$ is less than 5 %, substantially no advantage of the present invention over the prior arts in which oxygen alone is used will be obtained. To the contrary, if the proportion of $N_2$ exceeds 80 %, a proportion of $O_2$ becomes too small to contribute actual reaction and the properties of the thin film obtained are rather deteriorated.

The flow rate of the mixed gas of $O_2$ and $N_2$ depends on the power of an evacuation system used but is preferably in a range of 0.1 to 50 cc/min.

The process according to the present invention can be performed very easily by replacing oxygen gas which was used as a reaction gas in the prior art by the mixed gas of $O_2$ and $N_2$, with substantially no change of the conventional film formation unit.

Conditions for preparing thin films in a MBE unit will be shown below but are mere examples for special cases. It is apparent that persons skilled in the art can select the optimum conditions depending on combinations of the oxide thin films and the substrate.

## Example of film forming conditions

| | | |
|---|---|---|
| Substrate temperature | : | 550 to 800 °C |
| Deposition rate | : | $10^{-11}$ to $10^{-9}$ m/sec (0.1 to 10 Å/sec) |
| Power of microwave | : | 50 to 500 W |
| Pressure in a chamber | : | 1,33 $10^{-4}$ to 1,33 $10^{-2}$ Pa (1.0 x $10^{-6}$ to 1.0 x $10^{-4}$ Torr) |
| Pressure in a zone where a plasma is created | : | 1,33 to 666,45 Pa (1.0 x $10^{-2}$ to 5 Torr) |
| Reaction gas flow rate | : | 0.1 to 50 cc/min |

Brief Description of the drawings

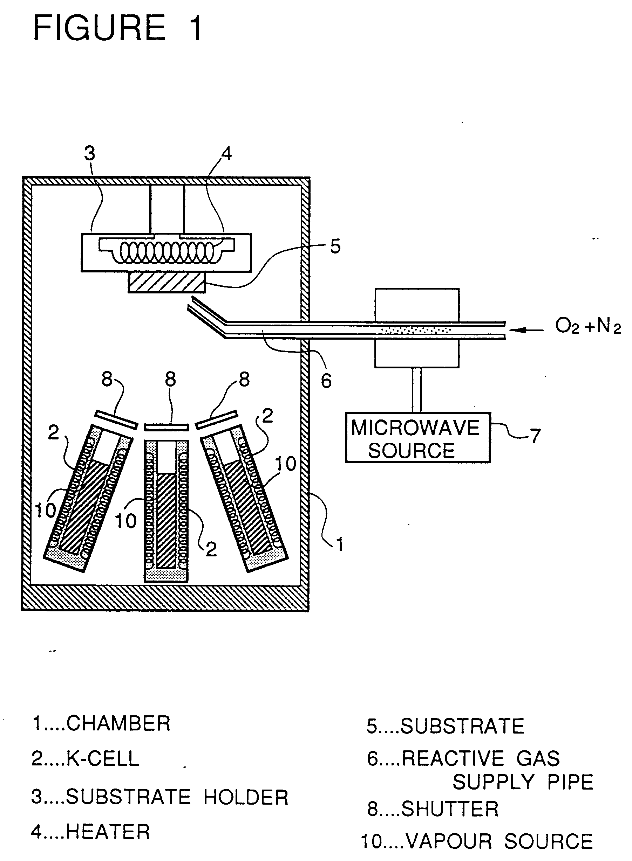

FIG. 1 is an illustrative view of a MBE unit for carrying out the process according to the present invention.

The process according to the present invention can be carried out in the MBE unit shown in Fig. 1. The MBE unit shown in Fig. 1 comprises a chamber 1 interior of which is evacuated to very high vacuum, a plurality of Kunudsen Cells (K-cells) 2 each of which can control a temperature of a vapour source 10 placed therein, a plurality of shutters 8 for controlling the amount or timing of each vapour source 10, a substrate holder 3 provided with a heater 4 for heating a substrate 5, and a reaction gas supply pipe 6 through which a reaction gas is supplied and being opened in the neighbourhood of a surface of the substrate 5. The reaction gas is excited by microwave discharge generated by a microwave source 7.

Now, the present invention will be described with reference to the following Example, but the scope of the invention should not be limited to said Example .

Example

A superconducting thin film of compound oxide according to the present invention of $Y_1 Ba_2 Cu_3 O_{7-x}$ was deposited on a {100} plane of a MgO single crystal substrate by the molecular beam epitaxy (MBE) unit illustrated in Fig. 1, with supplying a gas mixture of $O_2$ and $N_2$ according to the present invention.

Six samples (1) to (6) of thin films were prepared under the following common conditions but proportions of $O_2$ and $N_2$ by volume were changed as are shown in Table 1:

| | |
|---|---|
| Vapour sources (temperature) | : elemental Y (pellet) 1.500 °C |
| | : elemental Ba (pellet) 690 °C |
| | : elemental Cu (pellet) 1.130 °C |
| Substrate temperature | : 600 °C |
| Deposition rate | : $5.10^{-11}$ m/sec (0.5 Å/sec) |
| Pressure in the chamber | : $6,66 \cdot 10^{-4}$ Pa ($5 \times 10^{-6}$ Torr) |
| Pressure in plasma generation zone | : 40 Pa (300 milli-Torr) |
| Power of microwave | : 100 W |
| Flow rate of reaction gas | : 0.5 cc/min |
| Film thickness | : $10^{-7}$ m (1,000 Å) |

The critical temperature (Tc) and the critical current density (Jc) determined on the resulting superconducting thin films are summarized in Table 1.

## Table 1

| Sample No | Reaction Gas | | Tc (K) | Jc (at 77K) (A/cm$^2$) |
|---|---|---|---|---|
| | O$_2$ (%) | N$_2$ (%) | | |
| 1* | 99 | 1 | 72 | 9.2 x 10$^3$ |
| 2 | 92 | 8 | 86 | 1.2 x 10$^6$ |
| 3 | 80 | 20 | 88 | 1.8 x 10$^6$ |
| 4 | 50 | 50 | 85 | 3.2 x 10$^6$ |
| 5 | 30 | 70 | 89 | 2.3 x 10$^6$ |
| 6* | 15 | 85 | 75 | 1.8 x 10$^4$ |

(note) 1* and 6* are comparative

From the Example, it was confirmed that superconducting thin films of compound oxides having high critical temperatures (Tc) and high critical current densities can be produced.

Although the present invention is described in details with referring to oxide superconductors, the process according to the present invention is apparently applicable to the other oxides.

## Claims

1. A process for preparing an oxide thin film on a substrate (5) by a vacuum evaporation method with an oxygen-containing gas excited by microwave discharge (7) being introduced in the neighbourhood of the substrate, characterized in that said oxygen-containing gas is a mixed gas of O$_2$ and N$_2$.

2. The process set forth in Claim 1 wherein said vacuum evaporation method is molecular beam epitaxy (MBE).

3. The process set forth in Claim 1 or 2 wherein the flow rate of said oxygen-containing gas is within a range of 0.1 to 50 cc/min.

4. The process set forth in any one of Claim 1 to 3 wherein the proportion of N$_2$ is between 5 and 80 % by volume.

5. The process set forth in any one of Claim 1 to 4 wherein the pressure in the vacuum chamber is within a range of 1,33 x 10$^{-4}$ to 1,33 x 10$^{-2}$ Pa (1.0 x 10$^{-6}$ to 1.0. x 10$^{-4}$ Torr).

6. The process set forth in any one of Claim 1 to 5 wherein the deposition rate is within a range of 10$^{-11}$ to 10$^{-9}$ m/sec (0.1 to 10 Å/sec).

7. The process set forth in any one of Claim 1 to 6 wherein the substrate temperature is within a range of 550 to 800 °C.

8. The process set forth in any one of Claim 1 to 7 wherein the power of the microwave for exciting the gas is within a range of 50 to 500 W.

9. The process set forth in any one of Claim 1 to 8 wherein the substrate is of a single crystal of oxide.

EP 0 412 007 B1

10. The process set forth in Claim 9 wherein the substrate is a single crystal of oxide selected from the group comprising $MgO$, $SrTiO_3$, $LaGaO_3$, $NdGaO_3$, $LaAlO_3$ or YSZ.

11. The process set forth in any one of Claim 1 to 10 wherein the oxide thin film is a superconducting thin film of compound oxide.

12. The process set forth in Claim 11 wherein said compound oxide has a composition represented by the general formula:

$$(La_{1-x}, \alpha)_2 Cu O_{4-y}$$

in which "$\alpha$" stands for Sr or Ba, and "x" and "y" are numbers each satisfying respective range of $0 \leqq x < 1$ and $0 \leqq y < 1$.

13. The process set forth in Claim 11 wherein said compound oxide has a composition represented by the general formula:

$$Ln_1 Ba_2 Cu_3 O_{7-z}$$

in which "Ln" stands for at least one element selected from a group comprising La, Ce, Pr, Nd, Sm, Eu, Gd, Tb, Dy, Ho, Y, Er, Tm, Yb and Lu, and "z" is a number satisfying a range of $0 \leq z < 1$.

14. The process set forth in Claim 13 wherein said compound oxide has a crystal structure of perovskite type or layered perovskite type.

15. The process set forth in Claim 11 wherein said compound oxide has a composition represented by the general formula:

$$Bi_4 (Sr_{1-x}, Ca_x)_m Cu_n O_{p+y}$$

in which "x", "m", "n", "p" and "y" are numbers each satisfying ranges of $6 \leqq m \leqq 10$, $4 \leqq n \leqq 8$ $0 < x < 1$ and $-2 \leqq y \leqq +2$, respectively and p = (6+m+n).

**Patentansprüche**

1. Verfahren zur Herstellung eines dünnen Oxidfilms auf einem Substrat (5) durch ein Vakuumverdampfungsverfahren, bei dem ein durch eine Mikrowellenentladung (7) angeregtes sauerstoffhaltiges Gas in der Nähe des Substrats eingeführt wird, dadurch gekennzeichnet, daß das sauerstoffhaltige Gas ein Gasgemisch aus $O_2$ und $N_2$ ist.

2. Verfahren nach Anspruch 1, bei dem das Vakuumverdampfungsverfahren eine Molekularstrahlepitaxie (MBE) ist.

3. Verfahren nach Anspruch 1 oder 2, bei dem die Durchflußgeschwindigkeit des sauerstoffhaltigen Gases im Bereich von 0,1 bis 50 cc/min liegt.

4. Verfahren nach einem der Ansprüche 1 bis 3, bei dem der Anteil an $N_2$ zwischen 5 und 80 Volumen-% beträgt.

5. Verfahren nach einem der Ansprüche 1 bis 4, bei dem der Druck in der Vakuumkammer im Bereich von 1,33 x 10$^{-4}$ bis 1,33 x 10$^{-2}$ Pa liegt (1,0 x 10$^{-6}$ bis 1,0 x 10$^{-4}$ Torr).

6. Verfahren nach einem der Ansprüche 1 bis 5, bei dem die Abscheiderate im Bereich von 10$^{-11}$ bis 10$^{-9}$ m/sec (0,1 bis 10 Å/sec) liegt.

7. Verfahren nach einem der Ansprüche 1 bis 6, bei dem die Substrattemperatur im Bereich von 550 bis 800° C liegt.

8. Verfahren nach einem der Ansprüche 1 bis 7, bei dem die Leistung der Mikrowelle zur Gasanregung im Bereich von 50 bis 500 W liegt.

9. Verfahren nach einem der Ansprüche 1 bis 8, bei dem das Substrat ein Oxid-Einkristall ist.

10. Verfahren nach Anspruch 9, bei dem das Substrat ein Oxid-Einkristall ist ausgewählt aus der Gruppe umfassend $MgO$, $SrTiO_3$, $LaGaO_3$, $NdGaO_3$, $LaAlO_3$ und YSZ.

6

11. Verfahren nach einem der Ansprüche 1 bis 10, bei dem der dünne Oxidfilm ein supraleitender dünner Film aus Verbundoxid ist.

12. Verfahren nach Anspruch 11, bei dem das Verbundoxid eine Zusammensetzung aufweist die durch die folgende allgemeine Formel gegeben ist:
$$(La_{1-x}, \alpha)_2CuO_{4-y}$$
wobei $\alpha$ für Sr oder Ba steht und x und y Zahlen sind, welche die Bereiche $0 \leqq x < 1$ bzw, $0 \leqq y < 1$ erfüllen.

13. Verfahren nach Anspruch 11, bei dem das Verbundoxid eine Zusammensetzung aufweist die durch die folgende allgemeine Formel gegeben ist:
$$Ln_1Ba_2Cu_3O_{7-z}$$
wobei Ln für wenigstens ein Element steht das ausgewählt ist aus einer Gruppe umfassend La, Ce, Pr, Nd, Sm, Eu, Gd, Tb, Dy, Ho, Y, Er, Tm, Yb und Lu und z eine Zahl ist im Bereich $0 \leqq z < 1$.

14. Verfahren nach Anspruch 13, bei dem das Verbundoxid eine Kristallstruktur vom Perovskit-Typ oder geschichteten Perovskit-Typ aufweist.

15. Verfahren nach Anspruch 11, bei dem das Verbundoxid eine Zusammensetzung aufweist die durch die folgende allgemeine Formel gegeben ist:
$$Bi_4(Sr_{1-x}, Ca_x)_mCu_nO_{p+y}$$
wobei x, m, n, p und y zahlen sind die die folgenden entsprechenden Bereiche erfüllen: $6 \leqq m \leqq 10$, $4 \leqq n \leqq 8$, $0 < x < 1$, $-2 \leqq y \leqq +2$ bzw. $p=(6+m+n)$.


## Revendications

1. Procédé pour préparer une pellicule mince d'oxyde sur un substrat (5) au moyen d'un procédé d'évaporation sous vide avec un gaz contenant de l'oxygène excité par une décharge de micro-ondes (7) laquelle est introduite au voisinage du substrat, caractérisé en ce que ledit gaz contenant de l'oxygène est un gaz mixte d'$O_2$ et de $N_2$.

2. Procédé selon la revendication 1, dans lequel le procédé d'évaporation sous vide est une épitaxie de faisceau moléculaire (EFM).

3. Procédé selon la revendication 1 ou la revendication 2, dans lequel le débit dudit gaz contenant de l'oxygène est compris dans la gamme de 0,1 à 50 cc/mn.

4. Procédé selon l'une quelconque des revendications 1 à 3, dans lequel la proportion de $N_2$ est comprise entre 5 et 80% en volume.

5. Procédé selon l'une quelconque des revendications 1 à 4, dans lequel la pression dans la chambre sous vide est comprise dans la gamme de $1,33 \times 10^{-4}$ à $1,33 \times 10^{-2}$ Pa ($1,6 \times 10^{-6}$ à $1,0 \times 10^{-4}$ torr).

6. Procédé selon l'une quelconque des revendications 1 à 5, dans lequel la vitesse de dépôt est comprise dans la gamme de $10^{-11}$ à $10^{-9}$ m/s (0,1 à 10 A/s).

7. Procédé selon l'une quelconque des revendications 1 à 6, dans lequel la température du substrat est comprise dans la gamme de 550 à 800°C.

8. Procédé selon l'une quelconque des revendications 1 à 7, dans lequel la puissance de la micro-onde pour exciter le gaz est comprise dans la gamme de 50 à 500 W.

9. Procédé selon l'une quelconque des revendications 1 à 8, dans lequel le substrat est un cristal unique d'oxyde.

10. Procédé selon la revendication 9, dans lequel le substrat est un cristal unique d'oxyde choisi parmi le groupe comprenant MgO, $SrTiO_3$, $LaGaO_3$, $NdGaO_3$, $LaAlO_3$ ou YSZ.

11. Procédé selon l'une quelconque des revendications 1 à 10, dans lequel la pellicule mince d'oxyde est une pellicule mince supraconductrice d'oxyde composé.

**12.** Procédé selon la revendication 11, dans lequel l'oxyde composé a une composition représentée par la formule générale :

$$(La_{1-x}, \alpha)_2 Cu\, O_{4-y}$$

dans laquelle "$\alpha$" représente Sr ou Ba et "x" et "y" sont des chiffres compris respectivement chacun dans la gamme : $O \leqq x < 1$ et $O \leqq y < 1$.

**13.** Procédé selon la revendication 11, dans lequel ledit oxyde composé a une composition représentée par la formule générale :

$$Ln_1 Ba_2 Cu_3 O_{7-z}$$

dans laquelle "Ln" représente au moins un élément choisi dans le groupe comprenant La, Ce, Pr, Nd, Sm, Eu, Gd, Tb, Dy, Ho, Y, Er, Tm, Yb et Lu et "z" est un chiffre compris dans la gamme de $O \leqq z < 1$.

**14.** Procédé selon la revendication 13, dans lequel ledit oxyde composé présente une structure cristalline du type perovskite ou du type perovskite à couches.

**15.** Procédé selon la revendication 11, dans lequel ledit oxyde composé a une composition représentée par la formule générale :

$$Bi_4 (Sr_{1-x}, CA_x)_m Cu_n O_{p+y}$$

dans laquelle "x", "m", "n", "p", et "y" sont des chiffres compris chacun dans les gammes de $6 \leqq m \leqq 10$, $4 \leqq n \leqq 8$ $0 < x < 1$ et $-2 \leqq y \leqq +2$ respectivement et $p = (6+m+n)$.

# FIGURE 1

1....CHAMBER

2....K-CELL

3....SUBSTRATE HOLDER

4....HEATER

5....SUBSTRATE

6....REACTIVE GAS
      SUPPLY PIPE

8....SHUTTER

10....VAPOUR SOURCE